# EUROPEAN PATENT APPLICATION

(11) **EP 2 642 834 A2**
(43) Date of publication of application: **25.09.2013**
(21) Application number: 12165415.6
(22) Date of filing: 24.04.2012
(51) Int. Cl.: H05K 1/02

(54) **Printed circuit board**

(30) Priority: 19.03.2012 CN 201210071359
(71) Applicant: Hong Fu Jin Precision Industry (ShenZhen) Co., Ltd., Shenzhen City, Guangdong 518109 (CN); Hon Hai Precision Industry Co., Ltd., New Taipei City (TW)
(72) Inventor: Gao, Fu-Li, 518109, Shenzhen City (CN); Lin, Kuo-Pin, Tu-Cheng, New Taipei (TW)
(74) Representative: Gray, John James

(57) **Abstract**

A printed circuit board includes an insulating layer and a conductive metal layer attached on the insulating layer. The conductive metal layer is grounded and is configured for providing grounding for electronic components mounted on the printed circuit board. The insulating layer includes an exposed portion free of the conductive metal layer thereon, and two pads are formed on the exposed portion of the insulating layer and are insulated from each other. An inductor is mounted on the exposed portion and is electrically connected to the two pads.

## Description

### Field

The present disclosure relates to layout structures of printed circuit boards and, particularly, to a layout structure of a printed circuit board capable of reducing electromagnetic interference.

### BackGround

Most electromagnetic interference generated in a printed circuit board can be reduced by grounding. However, a poor layout of a ground layer may strengthen the electromagnetic interference.

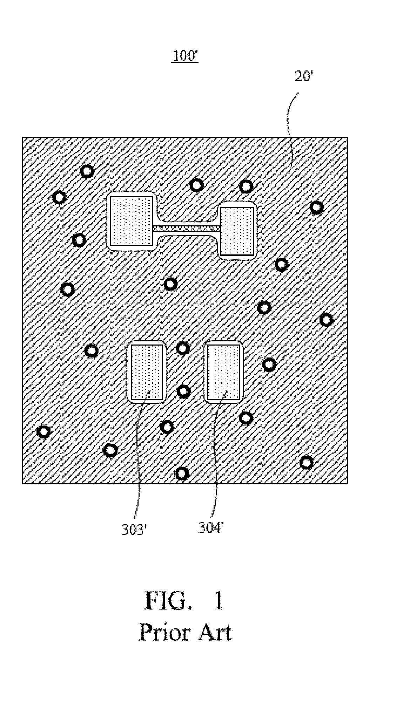

For example, referring to FIG. 1, a printed circuit board 100' of an electronic device, such as a Digital Versatile Disc (DVD) player, includes a power switch circuit (not shown) used for repeatedly charging and discharging. A copper foil (shown as the shadow) 20' laid on the entire printed circuit board 100' is connected to a ground of the printed circuit board 100', to form a high current ground loop, which is capable of reducing the electromagnetic interference generated in the printed circuit board 100'.

Most electronic components in the printed circuit board 100', such as a Power Management IC, include a ground pin to form a ground loop, and then connect to the high current ground loop formed by the copper foil 20' via the ground pin, thus eliminating or reducing the electromagnetic interference generated therein. However, an inductor used for repeatedly charging and discharging included in the power switch circuit and connected to the printed circuit board 100' by pads 303' and 304' does not include a ground pin. Thereby, the high-order harmonic distortion and noise generated by the inductor during the process of repeatedly charging and discharging can only be reduced or eliminated by the copper foil covered by the inductor. But due to the fact a path of a loop formed by the ground of the printed circuit board 100' and the copper foil covered by the inductor is long, a portion of high-order harmonic distortion and noise may flow to other electronic components of the printed circuit board 100' via the copper foil 20' during the high-order harmonic distortion and noise is conducted to the ground, thus increasing the interference of the electromagnetic interference to the other electronic components.

### Summary

According to one aspect of the disclosure, a printed circuit board is provided. The printed circuit board includes an insulating layer, a conductive metal layer, two pads and an inductor. The conductive metal layer is attached on the insulating layer and is grounded, which is configured for providing grounding for electronic components mounted on the printed circuit board. The insulating layer includes an exposed portion free of the conductive metal layer thereon, and the two pads are formed on the exposed portion of the insulating layer and are insulated from each other. The inductor is mounted on the exposed portion and is electrically connected to the two pads. Thereby a spread path of electromagnetic interference generated by the inductor is cut off, and the interference of the electromagnetic interference to the other electronic components can be effectively reduced.

### BRIEF DESCRIPTION OF THE DRAWINGS

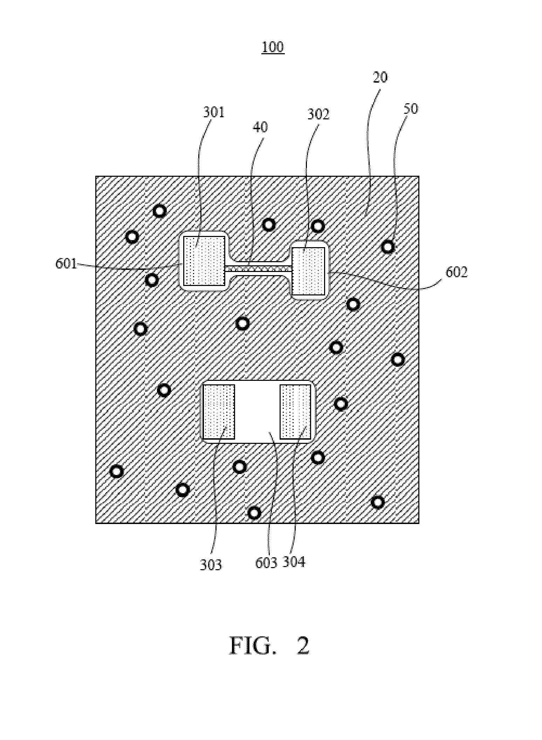

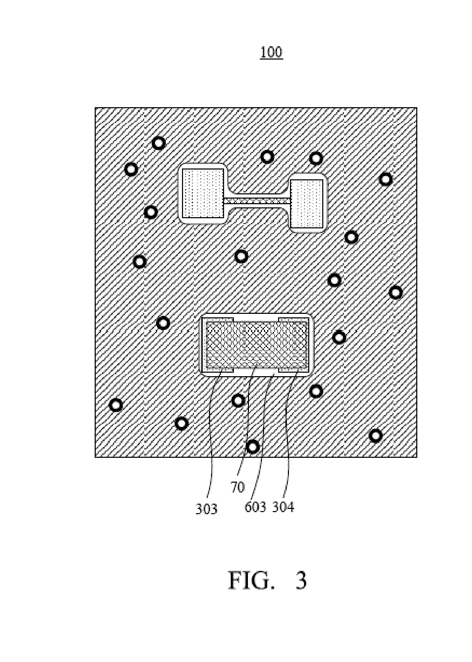

Embodiments of the invention are described, by way of example only, with reference to the accompanying drawings, in which:
FIG. 1 is a conventional layout structure diagram of a printed circuit board in an electronic device.
.FIG. 2 is a layout structure diagram of a printed circuit board in an electronic device, according to an embodiment.
.FIG. 3 is the layout structure diagram of the printed circuit board of FIG. 2, showing an inductor soldered in the printed circuit board.

### DETAILED DESCRIPTION

FIG. 2 is a layout structure of a printed circuit board 100 capable of reducing electromagnetic interference employed in an electronic device (such as DVD player). The printed circuit board 100 includes an insulating layer, a conductive metal layer (shown as the shadow) 20, a number of pads, such as pads 301∼304 for soldering connecting electronic components, and a number of printed conductors 40 for connecting electronic components. In the embodiment, the printed board 100 in FIG. 2 only shows a portion of the layout structure of a power switch circuit of the electronic device.

In the embodiment, the conductive metal layer 20 is attached on the insulating layer, and is connected to an internal ground of the printed circuit board 100 for providing grounding for electronic components mounted on the printed circuit board 100. In the embodiment, the conductive metal layer 20 is a grounded copper foil attached on the insulating layer and is for absorbing the electromagnetic interference generated in the printed circuit board 100. In the embodiment, the insulating layer includes a number of exposed portions 601∼603 free of the conductive metal layer thereon, and pads 301∼304 and the printed conductors 40 are formed on the exposed portions of the insulating layer and are insulated from each other. Thus, the conductive metal layer 20 is separated from the pads 301∼304 and the printed conductors 40 to avoid the case of short-circuit. A number of grounding holes 50 connected to the internal ground of the printed circuit board 100 are arranged in the conductive metal layer 20 for radiating heat energy and providing space for thermal expansion.

Referring to FIG. 3, the power switch circuit includes an inductor 70 for charging and discharging repeatedly. In the embodiment, the inductor 70 is a chip inductor and is connected to the power switch circuit by being mounted on the exposed portion 603 and being electrically connected to the two pads 303 and 304. The two pads 303 and 304 are insulated from each other and no copper foil 20 covers a predetermined range of area between the two pads 303 and 304. Thereby a spread path of a high-order harmonic distortion and noise generated by charging and discharging process of the inductor 70 is cut off to prevent high-order harmonic distortion and noise going to other components on the printed circuit board 100. Therefore, the interference of the electromagnetic interference to the other electronic components can be effectively reduced.

It should be emphasized that the above-described embodiments of the present disclosure, particularly, any embodiments, are merely possible examples of implementations, merely set forth for a clear understanding of the principles of the disclosure. Many variations and modifications may be made to the above-described embodiment(s) of the disclosure without departing substantially from the spirit and principles of the disclosure. All such modifications and variations are intended to be included herein within the scope of this disclosure and the present disclosure and protected by the following claims.

## Claims

1. A printed circuit board comprising:
an insulating layer;
a conductive metal layer attached on the insulating layer, the conductive metal layer grounded and configured for providing grounding for electronic components mounted on the printed circuit board, the insulating layer comprising an exposed portion free of the conductive metal layer thereon;
two pads formed on the exposed portion of the insulating layer and insulated from each other; and
an inductor mounted on the exposed portion and electrically connected to the two pads.

2. The printed circuit board according to claim 1, wherein the conductive metal layer is a grounded copper foil attached on the insulating layer.

3. The printed circuit board according to claim 1, wherein the inductor is a chip inductor.

4. The printed circuit board according to claim 1, further comprising a power switch circuit.
